# NEUE EUROPÄISCHE PATENTSCHRIFT

(11) **EP 0 437 731 B2**
(45) Veröffentlichungstag und Bekanntmachung des Hinweises auf die Entscheidung über den Einspruch: **08.05.2002**
(45) Hinweis auf die Patenterteilung: 22.02.1995
(21) Anmeldenummer: 90123839.4
(22) Anmeldetag: 11.12.1990
(51) Int. Cl.: H03J 7/28, H03J 5/02

(54) **Fernsehempfangsgerät mit einer Einrichtung zum Sendersuchlauf und zum Abspeichern fernsehsenderindividueller Informationen**
TV receiver apparatus with a transmitter scanning device and a memory for storing individual items of TV transmitter information
Appareil récepteur de télévision avec dispositif de balayage d'émetteurs et mémorisation d'informations individuelles d'émetteurs TV

(30) Priorität: 15.12.1989 DE 3941627
(43) Veröffentlichungstag der Anmeldung: 24.07.1991
(73) Patentinhaber: BSH Bosch und Siemens Hausgeräte GmbH, 81669 München (DE)
(72) Erfinder: Lerch, Dietmar, W-8060 Dachau (DE); Nickel, Rüdiger, 8032 Gräfelfing/Lochham (DE)

(56) Entgegenhaltungen:
- DE-A- 3 039 640
- DE-A- 3 236 696
- DE-A- 3 733 028
- DE-C- 2 746 186
- GB-A- 2 104 744

## Beschreibung

Die Erfindung betrifft ein Fernsehempfangsgerät nach dem Oberbegriff des Patentanspruchs 1.

Aus der DE-PS 31 45 407 ist bereits eine Einrichtung zum automatischen Programmieren eines Stationsspeichers und zum Voreinstellen eines von dem Stationsspeicher steuerbaren Fernsehempfangs-Tuners bekannt, wobei davon ausgegangen wird, daß in Fernsehsignale senderseitig codierte Zusatzinformationen über sämtliche, dem jeweiligen Sender im zeitlichen Wechsel zugeordnete Programmquellen (beispielsweise "ARD" (= Erstes Fernsehprogramm der BR Deutschland), "ZDF" (Zweites Deutsches Fernsehen)) eingefügt wird.
Die bekannte Einrichtung wird selbsttätig in der Weise programmiert, daß zunächst aus einem zwischengespeicherten Informationsbündel (Tabelle I) für jede einzelne Programmquelle die Empfangsfrequenz mit der besten Empfangsfeldstärke ausgewählt wird. Das Ergebnis dieses Auswahlschrittes wird in einer Tabelle II abgespeichert. Schließlich ist jeder Empfangsfrequenz in Tabelle II ein Stationstastenspeicher (Tabelle III) zuzuordnen. Das für die Durchführung dieser Vorgänge erforderliche Programm erweist sich als relativ komplex. Darüberhinaus ist bei der bekannten Vorrichtung eine erhebliche Kapazität zur Speicherung bzw. Zwischenspeicherung von Daten vorzusehen.

Der Erfindung liegt demgegenüber die Aufgabe zugrunde, ein Fernsehempfangsgerät der eingangs genannten Art zu schaffen, das eine vergleichsweise einfache Einstellung von Stationsspeichern ermöglicht.

Diese Aufgabe wird erfindungsgemäß durch die kennzeichnenden Merkmale des Patentanspruchs 1 gelöst.

Die Erfindung zeichnet sich durch den Vorteil aus, daß die Einstellung der Stationsspeicher in wenigen Schritten erfolgt und damit auch in vergleichsweiser kurzer Zeit erfolgt.
Darüberhinaus ermöglicht die Erfindung, Fernsehempfangsgeräte auch in Ländern zu betreiben, in denen Fernsehsendersignale mit Kennungssignalen abgestrahlt werden, die sich von Kennungssignalen im Inland unterscheiden.

Befinden sich im Empfangsbereich des Fernsehempfangsgeräts mehrere Fernsehsender, die Fernsehsignale mit fernsehsenderindividueller Frequenz jedoch mit gleicher Kennung abstrahlen, so wird vorteilhafterweise aus den Fernsehsignalen gleicher Kennung dasjenige mit der größten Feldstärke ausgewählt.

Die Erfindung wird nun anhand einer Blockschaltbildes beschrieben. Ein Fernsehempfangsgerät F enthält eine erfindungsgemäße Einrichtung mit einer Steuerung CPU, die über einen Datenbus DB mit einem Arbeitsspeicher MEM, einem Steuerungsbetriebsprogramm-Speicher RAM sowie mit Stationstasten T1, T2, ...Tn und gegebenenfalls mit einer Tastatur E verbunden ist.

Der Speicher MEM weist vorzugsweise 2n paarweise miteinander verknüpfte Speicherplätze Mf1MA1, Mf2MA2, ... MFnMAn auf. Die n Speicherplätze Mf1, Mf2, ... Mfn dienen der Aufnahme von Senderfrequenzinformationen f'1, f'2, ... f'n, während die n Speicherplätze MA1, MA2, ... MAn der Aufnahme von Feldstärkeinformationen A'1, A'2, ... A'n dienen. Die Speicherplätze MfxMAx (x = 1...n) sind über Fernsehsender-Kennungssignale Kx bezeichnende Adressdaten K'x adressierbar. Der Speicher MEM ist als nichtflüchtiger Speicher ausgebildet

Die Stationstasten T1, T2, ... Tn sind den Speicherplatzpaaren Mf1MA1, Mf2MA2, ... MfnMAn fest zugeordnet.

Nach Durchführung des Einstellvorgangs, der noch beschrieben wird, läßt sich durch Betätigung jeweils einer Stationstaste die in dem zugehörigen Speicherplatzpaar abgespeicherte Fernsehsenderfrequenzinformation abrufen und das Fernsehempfangsgerät auf die der abgerufenen Frequenzinformation entsprechende Frequenz einstellen.

Der Sendersuchlauf und die Einstellung der Stationsspeicher läßt sich durch Betätigung einer im Blockschaltbild nicht dargestellten Sondertaste auslösen. Diese Sondertaste kann in einer Tastatur E integriert sein, mit der zur Voreinstellung der Speicherplatzpaare MfxMAx des Arbeitsspeichers MEM Adressdaten K'x gebildet und durch die Steuerung CPU den zugehörigen Speicherplatzpaaren MfxMAx zugeführt werden. Die Tastatur E ist nurfakultativ vorgesehen; sie kann entfallen, wenn der Arbeitsspeicher MEM mechanisch in der Weise ausgebildet ist, daß er manuell in die Einrichtung einführbar bzw. aus dieser herausnehmbar ist Der Speicherkörper weist hierzu beispielsweise mechanisch stabile Kontaktfahnen auf, die in korrespondierende Bohrungen einführbar sind, und im eingeführten Zustand einen galvanischen Kontakt zu den übrigen Komponenten der Einrichtung bilden. Damit lassen sich Arbeitsspeichermodule mit extern voreingestellten Adressdaten, die länderspezifischen Kennungssignalen entsprechen, in einfacher Weise in die Einrichtung einbringen bzw. austauschen.

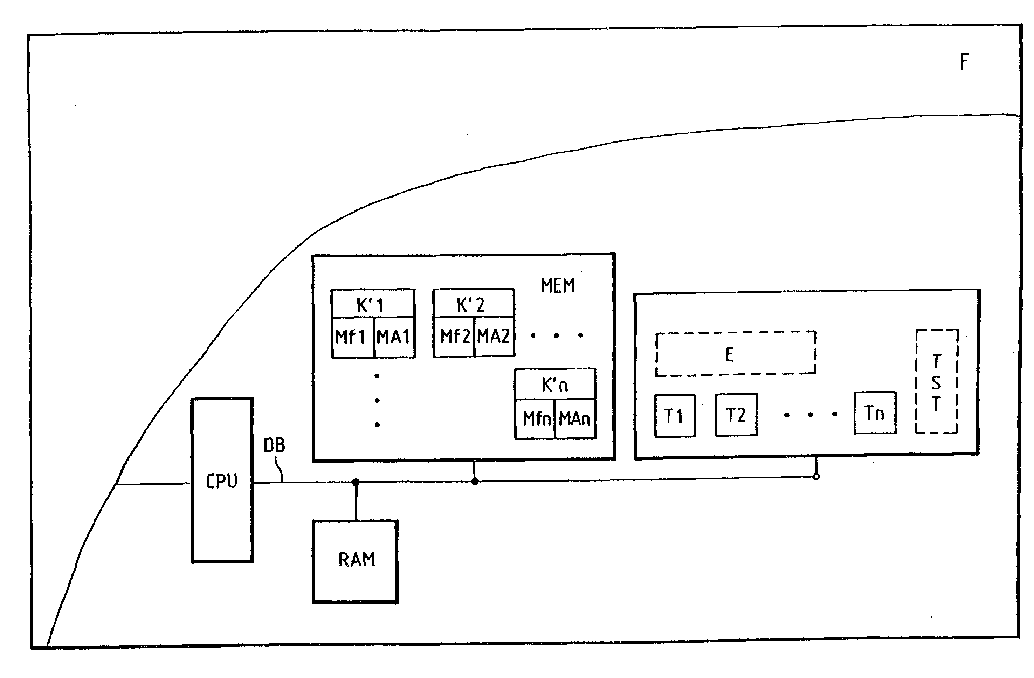

Den Stationstasten sowie der Sondertaste bzw. der Tastatur E kann eine mit der Steuerung CPU zusammenwirkende Steuerung TST zugeordnet sein. Die Tasten T1 ... Tn, E können mit der Steuerung TST in einem Fernbedienungsgeber angeordnet sein und mit der Steuerung CPU drahtlos über in der Figur nicht dargestellte Sende- und Empfangseinrichtungungen beziehungsweise über eine nicht dargestellte Verbindungsleitung verbunden sein.

Nicht dargestellt sind die für sich bekannten Einrichtungen des Fernsehempfangsgeräts zur Durchführung des Sendersuchlaufs, der Detektion von Fersehsenderfrequenzen f1 ... fn, Fernsehsenderfeldstärken A1 ... An und der Kennungssignale K1 .. Kn sowie zur Bildung entsprechender Informationen f'1 ...f'n, A'1 ... A'n und K'1 ... K'n in vorzugsweise digitaler Darstellung.

Die Steuerungsoperationen, die durch das im Speicher RAM abgelegte Steuerungsbetriebsprogramm definiert sind, werden im folgenden beschrieben, wobei von der Möglichkeit ausgegangen wird, daß im Empfangsbereich mehrerer Fernsehsender Signale dieser Sender entsprechend ihrer Sendeleistung und ihrer Entfernung zu einem bestimmten Empfangsort mit unterschiedlichen Feldstärkewerten empfangen werden können. Von diesen Werten hängt die Bild- und Tonqualität am Empfangsort ab. Aus diesem Grunde werden Fernsehsignale großer Feldstärke gegenüber Fernsehsignalen gleicher Kennung, aber geringerer Feldstärke bei der Einstellung des Arbeitsspeichers bevorzugt.

Ausgelöst durch einen beispielsweise durch eine Sondertaste oder eine Taste der Tastatur E erzeugten Startbefehl initiiert die Steuerung CPU einen Sendersuchlauf und detektiert dabei mittels entsprechender Einrichtungen Fernsehsenderfrequenzen fx, die zugehörigen Feldstärkewerte Ax sowie die Kennungssignale Kx (x = 1 ... n).
Die Kennungssignale Kx sind beispielsweise in Teletextdaten (Videotextdaten) enthalten, die gemeinsam mit dem Fernsehsignal übertragen werden.

Die Steuerung CPU veranlaßt die Bildung bzw. Codierung entsprechender Informationen f'x, A'x, K'x in vorzugsweise digitaler Darstellung und prüft anhand eines Vergleichs der Kennungssignalinformation K'x des empfangenen Fernsehsignals mit den Adressendaten der Speicherplatzpaare MfxMAx, ob ein Speicherplatzpaar vorhanden ist, dessen Adresse gleich dem empfangengen Kennungssignal Kx bzw. der Kennnungssignalinformation K'x ist

Soweit diese Prüfung ein positives Ergebnis liefert, vergleicht die Steuerung CPU die die Feldstärke Ax bezeichnende Informationen des gerade im Rahmen des Sendersuchlaufs empfangenen Fernsehsignals mit einer gegebenenfalls in dem betreffenden Speicherplatz abgespeicherten Feldstärkeinformation.

Ergibt dieser Vergleich, daß die Feldstärke des gerade empfangenen Signals großer als der bereits abgespeicherte Feldstärkewert ist, überschreibt die Steuerung CPU die in dem betreffenden Speicherplatzpaar abgespeicherte Frequenz- und Feldstärkeinformation mit der Frequenz- und Feldstärkeinformation des gerade empfangenen Signals.

Ergibt dieser Vergleich dagegen, daß die Feldstärke des gerade empfangenen Signals kleiner oder gleich dem bereits abgespeicherten Feldstärkewert ist, veranlaßt die Steuerung die Fortsetzung des Sendersuchlaufs, sofern dieser wegen Erreichen der Frequenzspektrumsgrenze nicht abgeschlossen ist.

Fernsehsignale, die gegenüber Fernsehsignalen gleicher Kennung eine kleinere Feldstärke aufweisen, werden also unterdrückt.

Die Einrichtung gemäß der Erfindung kann anstelle eines auswechselbaren Arbeitsspeichers einen festen Arbeitsspeicher mit veränderbaren Adressendaten K'x aufweisen, die durch die Tastatur E in Verbindung mit der Steuerung CPU gebildet und in die Adresssenspeicherplätze Kx der Speicherplatzpaare MfxMAx eingespeichert werden.

Nach Durchführung des Sendersuchlaufs und der Abspeicherung der gebildeten Frequenz- und Feldstärkeinformationspaare f'1A'1 ... f'nA'n in den Speicherplatzpaaren Mf1MA1 ... MfnMAn läßt sich durch Betätigung jeweils einer Stationstaste T1 ... Tn das Fernsehgerät F auf die entsprechende Senderfrequenz f1 ... fn einstellen.

Ein Sendersuchlauf und die beschriebene Abspeicherung der fernsehsenderindividuellen Daten wird in der Regel nur bei der Erstinbetriebnahme eines Fernsehempfangsgeräts an einem bestimmten Empfangsort durchgeführt Darüberhinaus ist ein Sendersuchlauf immer dann auszulösen, wenn eine Änderung der Empfangsfeldstärken wie beispielsweise bei einer Senderstörung auftritt.

## Patentansprüche

1. Fernsehempfangsgerät mit einer Einrichtung zum Sendersuchlauf und zum Abspeichern fernsehsenderindividueller Informationen, wobei die Einrichtung eine Steuerung (CPU), einen Speicher(RAM) zur Aufnahme eines Steuerungsbetriebsprogramms, einen Arbeitsspeicher (MEM) mit verknüpften Speicherplatzpaaren (MfxMAx; x = 1 ... n) zur Aufnahme fernsehsenderindividueller Informationen, nänlich Fernsehsenderfrequenz (fx) und Fernsehsenderfeldstärke (Ax) bezeichnende Informationen (f'x, A'x) sowie Stationstasten (Tx) aufweist, wobei die Speicherplatzpaare (MfxMAx) des Arbeitsspeichers (MEM) durch Fernsehsender-Kennungssignale (Kx) bezeichnende Adressdaten (K'x) adressierbar sind,
**dadurch gekennzeichnet,**
**daß** die Stationstasten (Tx) den Speicherplatzpaaren (MfxMAx) fest zugeordnet sind und daß die Einrichtung in der Weise ausgebildet ist, daß der Arbeitsspeicher (MEM) voreingestellte Adressdaten (K'x) enthält oder daß alternativ hierzu die Adressdaten (K'x) zur Voreinstellung der Speicherplatzpaare (MfxMAx) des Arbeitsspeichers (MEM) mittels einer Tastatur (E) in den Arbeitsspeicher (MEM) eingebbar sind.

2. Fernsehempfangsgerät nach Anspruch 1,
**dadurch gekennzeichnet,**
**daß** der Arbeitsspeicher(MEM) mit voreingestellten Adressdaten (K'x) manuell auswechselbar ist.

3. Fernsehempfangsgerät nach Anspruch 1 oder 2,
**dadurch gekennzeichnet,**
**daß** die Stationstasten (Tx) in einem Fernbedienungsgeber angeordnet sind, der mit der Steuerung (CPU) drahtlos oder mittels einer Verbindungsleitung verbindbar ist.

4. Fernsehempfangsgerät nach einem der vorangegangen Ansprüche,
**dadurch gekennzeichnet,**
**daß** der Arbeitsspeicher (MEM) als nichtflüchtiger Speicher ausgebildet ist

## Claims

1. Television receiver apparatus with an equipment for transmitter search and for storage of television-transmitter-specific data, wherein the equipment comprises a control device (CPU), a storage device (RAM) for reception of a control device operating program, a working storage device (MEM) with linked storage place pairs (MfxMAx; x = 1 ... n) for reception of television-transmitter-specific data, namely data (f'x, A'x) denoting television transmitter frequency (fx) and television transmitter field strength (Ax), as well as station buttons (Tx), wherein the storage place pairs (MfxMAx) of the working storage device (MEM) are addressable by address data (K'x) denoting television transmitter recognition signals (Kx), **characterised** thereby that the station buttons (Tx) are fixedly associated with the storage place pairs (MfxMAx) and that the equipment is constructed in the manner that the working storage device (MEM) contains preset address data (K'x) or that alternatively thereto the address data (K'x) can be input into the working storage device (MEM) by means of a keyboard (E) for presetting of the storage place pairs (MfxMAx) of the working storage device (MEM).

2. Television receiver apparatus according to claim 1, **characterised** thereby that the working storage device (MEM) is manually substitutable with preset address data (K'x).

3. Television receiver apparatus according to claim 1 or 2, **characterised** thereby that the station buttons (Tx) are arranged in a remote control transmitter, which is connected with the control device (CPU) without wires or by means of a connecting lead.

4. Television receiver apparatus according to one of the preceding claims, **characterised** thereby that the working storage device (MEM) is constructed as a non-volatile device.

## Revendications

1. Appareil récepteur de télévision comportant un dispositif de recherche des émetteurs et de mémorisation d'informations individualisées par émetteur de télévision, dans lequel le dispositif comporte une commande (CPU), une mémoire (RAM) pour l'enregistrement d'un programme pour faire fonctionner la commande, une mémoire de travail (MEM) avec des couples liés d'emplacements mémoire (MFxMAx ; x = 1 ... n) pour l'enregistrement d'informations individualisées par émetteur de télévision, à savoir d'informations (f'x, A'x) décrivant la fréquence d'émetteur de télévision (fx) et le niveau de champ d'émetteur de télévision (Ax), ainsi que des touches de station (Tx), dans lequel les couples d'emplacements mémoire (MfxMax) de la mémoire de travail (MEM) sont adressables par des données d'adressage (K'x) décrivant des signaux d'identification d'émetteur de télévision (Kx),
**caractérisé en ce que**
les touches de station (Tx) sont associées à demeure aux couples d'emplacements mémoire (MfxMAx) et le dispositif est agencé d'une manière telle que la mémoire de travail (MEM) contienne des données d'adressage préétablies (K'x) ou que, en alternative à ceci, on puisse introduire dans la mémoire de travail (MEM) par l'intermédiaire d'un clavier (E) les données d'adressage (K'x) pour le préétablissement des couples d'emplacements mémoire (MfxMax) de la mémoire de travail (MEM).

2. Appareil récepteur de télévision selon la revendication 1,
**caractérisé en ce que**
l'on peut modifier manuellement dans la mémoire de travail (MEM) des données d'adressage préétablies (K'x).

3. Appareil récepteur de télévision selon la revendication 1 ou 2,
**caractérisé en ce que**
les touches de station (Tx) sont situées dans un émetteur de télécommande qui peut être relié sans fil ou par l'intermédiaire d'un conducteur de liaison à la commande (CPU).

4. Appareil récepteur de télévision selon l'une des revendications précédentes,
**caractérisé en ce que**
la mémoire de travail (MEM) est réalisée sous forme d'une mémoire non volatile.
